# EUROPEAN PATENT APPLICATION

(11) **EP 4 386 868 A1**
(43) Date of publication of application: **19.06.2024**
(21) Application number: 22874222.7
(22) Date of filing: 11.05.2022
(51) Int. Cl.: H01L 31/0288, H01L 31/0216, H01L 31/0352, H01L 31/18

(54) **BACK CONTACT CELL AND MANUFACTURING METHOD THEREFOR**

(30) Priority: 30.09.2021 CN 202111162148
(71) Applicant: Longi Solar Technology (Taizhou) Co., Ltd., Taizhou, Jiangsu 225300 (CN)
(72) Inventor: LI, Zhonglan, Taizhou, Jiangsu 225300 (CN); LU, Weiming, Taizhou, Jiangsu 225300 (CN); LI, Hua, Taizhou, Jiangsu 225300 (CN); JIN, Yupeng, Taizhou, Jiangsu 225300 (CN)
(74) Representative: Loo, Chi Ching
(86) International application number: PCT/CN2022/092271
(87) International publication number: WO 2023/050824

(57) **Abstract**

A back-contact cell and a manufacturing method therefor are disclosed by the present application, which relate to the field of photovoltaic technology, and used to simplify the manufacturing process of the back-contact cell while ensuring that photoelectric conversion efficiency is high. The back-contact cell includes a substrate, wherein the substrate has a first surface and a second surface facing to each other, on the first surface, there are a first doping region and a second doping region arranged in a staggered way, an overlapping region and a third region that are located between the first doping region and the second doping region, the overlapping region is close to the first doping region; a first doping layer formed on the first doping region and the overlapping region; a second doping layer formed on the first doping layer and located at an upper portion of the overlapping region; a third doping layer formed on the second doping region, wherein conductive types of the third doping layer and the second doping layer are opposite to a conductive type of the first doping layer; a first electrode electrically contacted with the first doping layer and a second electrode electrically contacted with the third doping layer. The manufacturing method provided by the present application is used to manufacture the back-contact cell.

## Description

### CROSS-REFERENCE TO RELATED APPLICATION

The present disclosure claims the priority of the Chinese patent application filed on September 30th, 2021 before the China National Intellectual Property Administration with the application number of 202111162148.1 and the title of "BACK CONTACT CELL AND MANUFACTURING METHOD THEREFOR", which is incorporated herein in its entirety by reference.

### TECHNICAL FIELD

The present disclosure relates to the field of photovoltaic technology and, more particularly, to a back-contact cell and a manufacturing method therefor.

### BACKGROUND

A back-contact cell refers to a cell that an emitter and metal contact are located on the back of the cell, and there are not metal electrodes shielding the front. Comparing with the cell with the front being shielded, the back-contact cell has higher short-circuit current and photoelectric conversion efficiency, and is one of the technical directions to achieve high-efficiency crystalline silicon cells.

The existing method for manufacturing the back-contact cell is more complicated, therefore a method for manufacturing the solar cell that is simple and that high-efficiency is ensured is needed.

### SUMMARY

An object of the present application is to provide a back-contact cell and a manufacturing method therefor, which are used to simplify the manufacturing process of the back-contact cell while ensuring that photoelectric conversion efficiency is high.

In a first aspect, a back-contact cell is provided by the present application, which includes: a substrate, wherein the substrate has a first surface and a second surface facing to each other, on the first surface, there are a first doping region and a second doping region arranged in a staggered way, an overlapping region and a third region that are located between the first doping region and the second doping region, the overlapping region is close to the first doping region; a first doping layer formed on the first doping region and the overlapping region; a second doping layer formed on the first doping layer, wherein the second doping layer is only located at an upper portion of the overlapping region, and a conductive type of the first doping layer is opposite to a conductive type of the second doping layer; a third doping layer formed on the second doping region, wherein a conductive type of the third doping layer is opposite to the conductive type of the first doping layer; and a first electrode and a second electrode, wherein the first electrode is electrically contacted with the first doping layer, and the second electrode is electrically contacted with the third doping layer.

In the case of using the technical solution stated above, on the first surface of the substrate, there is an overlapping region located between the first doping region and the second doping region and close to the first doping region. On the overlapping region, there are a first doping layer and a second doping layer formed in turn. The conductive type of the first doping layer is opposite to the conductive type of the second doping layer. Based on this, the second doping layer covers the first doping layer below the second doping layer, a part of the surface of the first doping layer is protected, the first doping layer at the overlapping region is avoided from being destroyed or introduced impurities during the subsequent process of treating processes, the yield and production efficiency of the back-contact cell is improved, at the same time, the collection of the first electrical carriers is ensured. In addition, for the retained second doping layer, the processing area and difficulty in the patterning treating process are reduced, the production cost is reduced, and the production capacity and the production efficiency during mass production are improved. In addition to this, the first doping layer on the first doping region can be separated from the third doping layer on the second doping region by using the third region, which is beneficial to ensure the excellent positive negative electrode insulation performance of the cell.

In some possible embodiments, the back-contact cell further includes a first protecting layer that is located at the upper portion of the overlapping region and located between the first doping layer and the second doping layer.

In the case of using the technical solution stated above, on the one hand, in the process of gradually forming a back-contact cell, the formed first protecting layer can protect the first doping layer during the subsequent processes of patterning treatment, surface texturing treatment, and cleaning, so that the first doping layer may not be corroded or damaged. On the other hand, the first doping layer and the second doping layer may be completely separated by the first protecting layer, therefore the adverse effects brought by the second doping layer on the first doping layer in the subsequent process are reduced. For example, in the case that there are not the first protecting layer, and the first doping layer is directly contacted with the second doping layer, when at least one of the first doping layer and the second doping layer is a doped amorphous silicon layer that needs to be crystallized into a doped polycrystalline silicon layer, since the crystallization time is long, and the conductive type of the second doping layer is opposite to the conductive type of the first doping layer. Long-term crystallization may cause the doping elements in the second doping layer to enter the first doping layer, which causes damage to the first doping layer, and may even change the conductive type of the first doping layer, resulting in that the cell cannot normally generate power.

In some possible embodiments, the first protecting layer includes at least one of a dielectric layer and a mask layer. The dielectric layer and/or the mask layer used by the first protecting layer are significantly different from the first doping layer in physical or chemical properties, so that when the first doping layer located on the second doping region and the third region is removed by using an etching process or a corroding process, the first protecting layer can be effectively retained.

In some possible embodiments, the first protecting layer includes one of a boron-silicon glass layer and a phosphorus silicon glass layer. At this moment, the first protecting layer can be formed by being doped with the first doping layer.

In some possible embodiments, a surface of the third region has a textured structure. There is not an electrode disposed on the third region, and the third region can be textured, so that there is a textured structure on the third region. Because the textured structure has a good light trapping effect and an anti-reflection effect, the light incident on the first surface can also be utilized, the light absorption effect of the back-contact cell on the first surface is increased, so that the back-contact cell can absorb light energy at both sides, the further utilization of light energy is realized and the power generation efficiency of the back-contact cell is improved.

In some possible embodiments, a surface of the first doping region and/or a surface of the second doping region and/or a surface of the overlapping region are polishing surfaces.

In the case of using the technical solution stated above, all of the surface of the first doping region, the surface of the second doping region and the surface of the overlapping region can be the polishing surfaces, so that the light incident from the second surface and passing through the back-contact cell can be re-reflected, so that there is an opportunity that the light can be reused by the back-contact cell. Thus, the photoelectric conversion efficiency of the back-contact cell is improved. In addition, the polished surface has better flatness, and the effect of subsequently forming other layers on the polishing surface may be better, the generation of interface defects is conducive to be reduced, therefore the recombination of carriers caused by defects is reduced, the passivation performance of the back-contact cell is conducive to be improved, therefore the photoelectric conversion efficiency of the back-contact cell is improved.

In some possible embodiments, the back-contact cell further includes a first interface passivation layer, a second interface passivation layer and a third interface passivation layer, wherein the first interface passivation layer is located between the substrate and the first doping layer, the second interface passivation layer is located between the second doping layer and the first protecting layer, and the third interface passivation layer is located between the substrate and the third doping layer. The substrate, the first protecting layer and the first doping layer are performed interface passivation by the first interface passivation layer, the second interface passivation layer and the third interface passivation layer, respectively, the recombination of the carriers at the interface is reduced and the transmission efficiency of the carriers is ensured.

In some possible embodiments, the substrate is an n-type substrate, the first doping layer is a p-type doping layer, the second doping layer and the third doping layer are n-type doping layers; or the substrate is p-type substrate, the first doping layer is the n-type doping layer, the second doping layer and the third doping layer are the p-type doping layers. When the substrate is the n-type substrate, the first doping layer is the p-type doping layer, the second doping layer and the third doping layer can be phosphorus-doped n-type doping layer. At this moment, since the phosphorus heavily doped region has the greater solubility for the metal impurities, the phosphorus in the second doping layer can provide the effect of phosphorus gettering and passivation for the first doping layer and the efficiency of the cell is improved.

In some possible embodiments, the back-contact cell further includes a first surface passivation layer, the first surface passivation layer is covered on the first doping layer, the second doping layer, the third doping layer and the third region; and a contacting surface of the first surface passivation layer and the first doping layer has a first opening, the first electrode is electrically contacted with the first doping layer through the first opening; and a contacting surface of the first surface passivation layer and the third doping layer has a second opening, the second electrode is electrically contacted with the third doping layer through the second opening.

In the case of using the technical solution stated above, a first surface passivation layer is formed at the outside of the first doping layer, the second doping layer, the third doping layer and the third region. The back-contact cell may be performed surface passivation by the first surface passivation layer, the dangling bonds at the first doping layer, the second doping layer, the third doping layer and the third region are passivated, the recombination speed of the carriers of the first surface is reduced, and the photoelectric conversion efficiency is improved. The first electrode and the second electrode are electrically contacted with the first doping layer and the third doping layer through the first opening and the second opening, respectively. Local ohmic contact between the metal and the semiconductor is formed, the contact area of the metal electrode with the first doping layer and the third doping layer is reduced, the contact resistance is reduced, the recombination rate of the carriers at the electrode surface is further reduced, and the open circuit voltage is increased.

In some possible embodiments, an area of the overlapping region accounts for 5% - 95 % of an area of the first doping layer. Optionally, the area of the overlapping region accounts for 20% - 95 % of the area of the first doping layer. The larger the area of the overlapping region, the larger the area of the first doping layer covered by the second doping layer, that is, the larger the area of the protected first doping layer, the first doping layer can better be protected from corrosion or damage in the subsequent process treatment. More preferably, the area of the overlapping region accounts for 40% - 75% of the area of the first doping layer. The first protecting layer and the second doping layer located at the upper portion of the overlapping region should be avoided contacting with the electrode. In addition, if the area of the overlapping region is too large, there is a risk of electric leakage.

In a second aspect, a method for manufacturing the back-contact cell is further provided by the present application, wherein the method includes:
providing a substrate, wherein the substrate has the first surface and the second surface facing to each other, on the first surface, there are the first doping region and the second doping region arranged in the staggered way, the overlapping region and the third region that are located between the first doping region and the second doping region, the overlapping region is close to the first doping region;
forming the first doping layer on the first surface of the substrate;
removing the first doping layer located on the second doping region and the third region;
forming a doping film layer on the first doping layer and the first surface;
removing the doping film layer located on the third region and the first doping region, so that the doping film layer located on the overlapping region is the second doping layer, and the doping film layer located on the first surface is the third doping layer; and
forming the first electrode on the first doping layer, and forming the second electrode on the third doping layer.

The beneficial effects of the method for manufacturing the back-contact cell provided by the second aspect or any possible embodiment of the second aspect may be referred to the beneficial effects of the back-contact cell described in the first aspect or any possible embodiment of the first aspect, which is not repeated here.

In some possible embodiments, the step of removing the first doping layer located on the second doping region and the third region is specifically as follows: forming a first protecting layer on the first doping layer of the first doping region and the overlapping region; removing the first doping layer and the first protecting layer on the second doping region and the third region.

In some possible embodiments, the step of removing the doping film layer located on the third region and the first doping region is specifically as follows: forming a second protecting layer on the doping film layer located on the overlapping region and the second doping region; removing the doping film layer located on the third region and the first doping region; and removing the second protecting layer.

In some possible embodiments, before the step of forming the first doping layer on the first surface of the substrate, the method further includes a step of forming a first interface passivation layer on the first surface of the substrate; in the step of removing the first doping layer located on the second doping region and the third region, the method further includes a step of removing the first interface passivation layer located on the second doping region and the third region; and/or after the step of removing the first doping layer located on the second doping region and the third region, and before the step of forming the doping film layer on the first doping layer and the first surface, the method further includes a step of forming an interface passivation film layer on the first protecting layer and the first surface; and in the step of removing the doping film layer located on the third region and the first doping region, the method further includes a step of removing the interface passivation film layer located on the third region and the first doping region, so that the interface passivation film layer located on the first protecting layer of the overlapping region is a second interface passivation layer, and the interface passivation film layer located on the first surface is a third interface passivation layer.

In some possible embodiments, a forming method of the first doping layer and the doping film layer is an in-situ doping method or an ex-situ doping method.

In some possible embodiments, after the step of removing the doping film layer located on the third region, the method further includes a step of texturing the third region.

In some possible embodiments, the step of forming the first electrode on the first doping layer, and forming the second electrode on the third doping layer is specifically as follows: forming a first surface passivation layer on the first doping layer, the second doping layer, the third doping layer and the third region; and forming the first electrode on the first surface passivation layer located on the first doping layer, and forming the second electrode on the first surface passivation layer located on the third doping layer, the first electrode is electrically contacted with the first doping layer and the second electrode is electrically contacted with the third doping layer.

In some possible embodiments, before the step of forming the first surface passivation layer on the first doping layer, the second doping layer, the third doping layer and the third region, the method further includes a step of preforming a heat treatment process, wherein at least a part of the first doping layer and/or the second doping layer and/or the third doping layer are crystallized during the heat treatment process.

In some possible embodiments, a way of removing the first doping layer located on the second doping region and the third doping region and/or removing the doping film layer located on the third region and the first doping region is alkali etching.

### BRIEF DESCRIPTION OF THE DRAWINGS

The drawings described here are used to provide a further understanding of the present application and are constituted to be a part of the present application. The schematic embodiments of the present application and their explanations are used to explain the present application, which does not constitute an improper limitation to the present application. In the drawings:
FIG. 1 to FIG. 3 are the schematic diagrams of structures of a back-contact cell according to the embodiments of the present application;
FIG. 4 to FIG. 13 are schematic diagrams of the states of stages of a manufacturing process of a back-contact cell according to the embodiments of the present application;
FIG. 14 is a schematic diagram of a first surface of a back-contact cell according to the embodiments of the present application;
FIG. 15 is a local enlarged diagram of FIG. 14;
FIG. 16 is a schematic diagram of the first surface of the back-contact cell with a continuous contact electrode according to the embodiments of the present application; and
FIG. 17 is a partial schematic diagram of the first surface of the back-contact cell with a local contact electrode according to the embodiments of the present application.

### Reference numbers

10-substrate, 101-first doping region, 102-second doping region, 103-third region, 104-overlapping region, 11-first doping layer, 12-doping film layer, 121-second doping layer, 122-third doping layer, 13-first surface passivation layer, 130-first opening, 131-second opening, 14-first interface passivation layer, 15-interface passivation film layer, 151-second interface passivation layer, 152-third interface passivation layer, 16-first protecting layer, 17-second protecting layer, 20-first electrode, 21-second electrode, 201-first electrode main electrode, 202-first electrode sub-gate line, 211-second electrode main electrode, 212-second electrode sub-gate line, 203-connecting electrode, 204-fine gate line, 18-second surface passivation layer and 205-local contacting point.

### DETAILED DESCRIPTION

To make the technical problems to be solved, the technical solutions, and beneficial effects of the present disclosure clearer, the following further describes some embodiments of the present disclosure in detail with reference to the accompanying drawings and embodiments. It should be understood that the specific embodiments described herein are merely illustrative of the present disclosure and are not intended to limit the present disclosure.

It should be noted that when an element is called to be "fixed on" or "arranged on" another element, it may be directly arranged on another element or indirectly arranged on another element. When an element is called to be "connected" to another element, it may be directly connected to another element or indirectly connected to another element.

Moreover, the terms "first" and "second" are only used for descriptive purposes, but cannot be understood as indicating or implying relative importance, or implicitly indicating the number of indicated technical features. Therefore, the features defined with "first" and "second" can explicitly or implicitly include one or more of the features. In the description of the present disclosure, the meaning of "a plurality of" is two or more than two, unless otherwise specifically defined. The meaning of "several" is one or more, unless otherwise specifically defined.

In the description of the present disclosure, it should be understood that the orientation or position relationship indicated by such terms as "upper", "lower", "front", "rear", "left", "right", or the like, is based on the orientation or position relationship shown in the drawings, which is only used for convenience of description of the present disclosure and simplification of description instead of indicating or implying that the indicated device or element must have a specific orientation, and be constructed and operated in a specific orientation, and thus shall not be understood as a limitation to the present disclosure.

In the description of the present disclosure, it should be noted that unless expressly stipulated and defined otherwise, terms such as "installation", "connected" and "connection", or the like, should be understood broadly, for example, the connection may be fixed connection, or detachable connection or integral connection; may be mechanical connection, and may also be electrical connection; and may be direct connection, may also be indirect connection through an intermediate medium, and may also be internal communication of two elements or interaction relationship of two elements. The specific meaning of the above terms in the present disclosure may be understood in a specific case by those having ordinary skills in the art.

As a new energy alternative solution, solar cells are more and more widely used at present. The solar cell is a device that converts the light energy of the sun into electrical energy. By using the photovoltaic principle, solar cells generate carriers, and then use the electrode to extract the carriers, which is conducive to the effective use of electrical energy.

Finger-shaped cross back-contact cell is also known as IBC cell. IBC refers to the interdigitated back contact. The biggest feature of the IBC cell is that the emitter and the metal contact are on the back of the cell, and there are not effects of metal electrode shielding on the front, therefore the IBC cell has a higher short-circuit current Isc, and at the same time, a wider metal gate line can be allowed on the back to reduce the series resistance Rs, thus the fill factor FF can be increased. Moreover, this cell without being shielded on the front not only has a high conversion efficiency, but also looks more beautiful, and at the same time, the components of the full-back electrode are easier to be assembled. The current IBC cell is one of the technical directions to achieve high-efficiency crystalline silicon cells.

However, since the method for manufacturing the IBC cell is more complicated, multi-step patterning process is usually required to complete the manufacturing. A method for manufacturing the solar cell that is simple and that high-efficiency is ensured is needed.

In order to solve the technical problems stated above, in the case of ensuring that photoelectric conversion efficiency is high, the manufacturing process of the back-contact cell is simplified, a back-contact cell is provided by the embodiments of the present application.

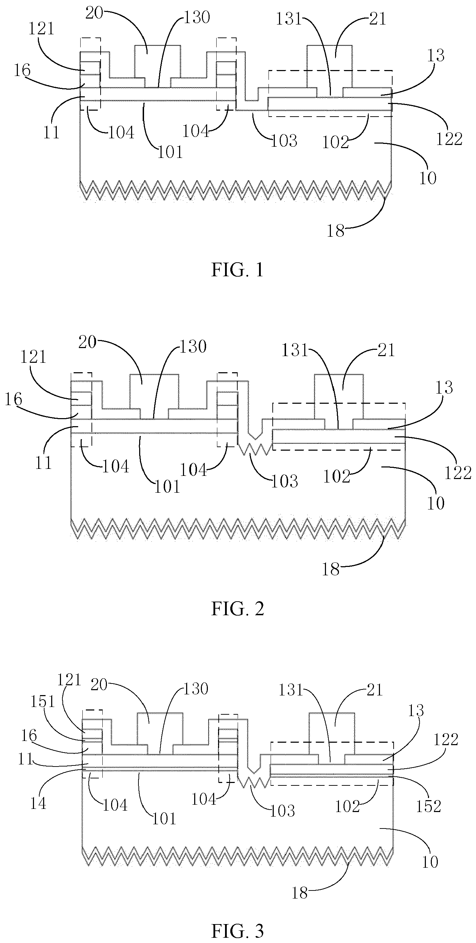

Referring to FIG. 1 to FIG. 3 and FIG. 14 to FIG. 15, a back-contact cell is provided by the embodiments of the present application, which includes: a substrate 10, wherein the substrate 10 has a first surface and a second surface facing to each other, on the first surface, there are a first doping region 101 and a second doping region 102 arranged in a staggered way, an overlapping region 104 and a third region 103 that are located between the first doping region 101 and the second doping region 102, the overlapping region 104 is close to the first doping region 101; a first doping layer 11 formed on the first doping region 101 and the overlapping region 104; a second doping layer 121 formed on the first doping layer 11, wherein the second doping layer 121 is only located at an upper portion of the overlapping region 104, and a conductive type of the first doping layer 11 is opposite to a conductive type of the second doping layer 121; a third doping layer 122 formed on the second doping region 102, wherein a conductive type of the third doping layer 122 is opposite to the conductive type of the first doping layer 11; and a first electrode 20 and a second electrode 21, wherein the first electrode 20 is electrically contacted with the first doping layer 11, and the second electrode 21 is electrically contacted with the third doping layer 122.

It can be seen from the structure of the back-contact cell stated above, on the first surface of the substrate 10, there is an overlapping region 104 located between the first doping region 101 and the second doping region 102 and close to the first doping region 101. On the overlapping region 104, there are a first doping layer 11 and a second doping layer 121 formed in turn. The conductive type of the first doping layer 11 is opposite to the conductive type of the second doping layer 121. Based on this, the second doping layer 121 covers the first doping layer 11 below the second doping layer, a part of the surface of the first doping layer 11 is protected, the first doping layer 11 at the overlapping region 104 is avoided from being destroyed or introduced impurities during the subsequent process of treating processes, the yield and production efficiency of the back-contact cell is improved, at the same time, and the collection of the first electrical carriers is ensured. In addition, for the retained second doping layer 121, the processing area and difficulty in the patterning treating process are reduced, the production cost is reduced, and the production capacity and the production efficiency during mass production are improved. In addition to this, the first doping layer 11 on the first doping region 101 can be separated from the third doping layer 122 on the second doping region 102 by using the third region 103, which is beneficial to ensure the excellent positive negative electrode insulation performance of the cell.

In some embodiments, as shown in FIG. 1 to FIG. 3, along the direction of the staggered arrangement of the first doping region 101 and the second doping region 102, the width of the third region 103 ranges from 10 µm to 100 µm. If the third region 103 is too wide, it may be led to that the effective area of the back-contact cell is wasted, the effective carriers are also difficult to be collected, thus the cell performance is reduced. The third region 103 is disposed between the first doping region 101 and the second doping region 102, so that the first doping region 101 and the second doping region 102 are separated from each other at the boundary, the insulator design between the positive electrode and the negative electrode in the prior art is canceled, the production process flow can be reduced and the space complexity can be reduced. Based on this structure, there is not a phenomenon of coexistence of positive and negative electrodes in the vertical direction. The generation of a phenomenon of electric leakage of the back-contact cell is avoided. Moreover, the reliability performance of the cell in the product at a later stage can be improved, and the difficulty of the production process of the back-contact cell is reduced.

Exemplarily, as shown in FIG. 1 to FIG. 3, the width of the third region 103 may be 10 µm, may also be 100 µm, and may also be 60 µm.

The substrate 10 is a semiconductor substrate 10. The material of the substrate 10 may be selected from the materials such as silicon (Si) or germanium (Ge) or materials such as gallium arsenide (GaAs). Obviously, in terms of the conductive type, the substrate 10 may be the intrinsic conductive substrate 10, the n-type conductive substrate 10 or the p-type conductive substrate 10. Optionally, the substrate 10 is the p-type conductive substrate 10 or the n-type conductive substrate 10. Compared with the intrinsic conductive substrate 10, the p-type conductive substrate 10 or the n-type conductive substrate 10 has a better conductivity, thus it is made that the back-contact cell that is finally manufactured has a lower volume resistivity, therefore the efficiency of the back-contact cell is improved.

Exemplarily, the substrate 10 is the n-type silicon substrate 10. Compared with the p-type conductive substrate 10, the n-type conductive substrate 10 has the advantages of high minority carrier lifetime, no light decay, good weak light performance and so on.

All of the first doping layer 11, the second doping layer 121 and the third doping layer 122 are also the semiconductor doping layers. In terms of the internal arrangement form of the substance, the first doping layer 11, the second doping layer 121 and the third doping layer 122 may be amorphous, microcrystalline, single crystal, nanocrystalline or polycrystalline and so on. In terms of specific materials, the materials of the first doping layer 11, the second doping layer 121 and the third doping layer 122 can be silicon (Si), germanium (Ge), silicon carbide (SiCx) or gallium arsenide (GaAs) and so on. In terms of the conductive type, the first doping layer 11, the second doping layer 121 and the third doping layer 122 can be the n-type doping layer or the p-type doping layer.

In some embodiments, when the substrate 10 is the n-type substrate 10, the first doping layer 11 can be the p-type doping layer, the second doping layer 121 and the third doping layer 122 can be the n-type doping layer; or, when the substrate 10 is the p-type substrate 10, the first doping layer 11 can be the n-type doping layer, the second doping layer 121 and the third doping layer 122 can be the p-type doping layer.

Exemplarily, as shown in FIG. 1 to FIG. 3, the substrate 10 is the n-type silicon substrate 10, the first doping layer 11 is boron-doped p-type doping layer, the second doping layer 121 and the third doping layer 122 are both phosphorus-doped n-type doping layers. At this moment, since the phosphorus heavily doped region has the greater solubility for the metal impurities, the phosphorus in the second doping layer 121 can provide the effect of phosphorus gettering and passivation for the first doping layer 11 and the efficiency of the cell is improved.

In the practical applications, when the first doping layer 11 on the first doping region 101 is the p-type doping layer, the overall laminated layer on the overlapping region 104 actually plays the role in the p-type doping layer, that is, the second doping layer 121 that is above the first doping layer 11 on the overlapping region 104 is not conductive. Only the first doping layer 11 on the first doping region 101 and the overlapping region 104 plays the role in transporting carriers. Then, the carriers on the first doping layer 11 are extracted by the first electrode 20 which is electrically contacted with the first doping layer 11. It can also be considered that the p-type region on the whole cell is the combination set of the first doping region 101 and the overlapping region 104.

As some possible embodiments, as shown in FIG. 1 to FIG. 3, the back-contact cell further includes a first protecting layer 16 that is located at the upper portion of the overlapping region 104 and located between the first doping layer 11 and the second doping layer 121.

Based on this, on the one hand, in the process of gradually forming a back-contact cell, the formed first protecting layer 16 can protect the first doping layer 11 during the subsequent processes of patterning treatment, surface texturing treatment, and cleaning, so that the first doping layer 11 may not be corroded or damaged. On the other hand, the first doping layer 11 and the second doping layer 121 may be completely separated by the first protecting layer 16, therefore the adverse effects brought by the second doping layer 121 on the first doping layer 11 in the subsequent process are reduced. For example, in the case that there are not the first protecting layer 16, and the first doping layer 11 is directly contacted with the second doping layer 121, when at least one of the first doping layer 11 and the second doping layer 121 is a doped amorphous silicon layer that needs to be crystallized into a doped polycrystalline silicon, since the crystallization time is long, and the conductive type of the second doping layer 121 is opposite to the conductive type of the first doping layer 11. Long-term crystallization may cause the doping elements in the second doping layer 121 to enter the first doping layer 11, which causes damage to the first doping layer 11, and may even make the conductive type of the first doping layer 11 change, resulting in that the cell cannot normally generate power. For example, in the absence of the first protecting layer 16, the first doping layer 11 is directly contacted with the second doping layer 121, when the first doping layer 11 is boron-doped p-type polycrystalline silicon layer, the second doping layer 121 is phosphorus-doped N-type amorphous silicon layer, and the second doping layer 121 needs to be crystallized into n-type polycrystalline silicon layer, the phosphorus element contained in the second doping layer 121 may enter the first doping layer 11 during the crystallization process, damage is caused to the first doping layer 11. If there is too much phosphorus element entering the first doping layer 11, the first doping layer 11 may be caused to change from P-type to N-type, the conductive type of the first doping layer 11 is the same as the conductive type of the substrate 10, resulting in that the cell cannot generate power.

In some embodiments, the first protecting layer 16 includes at least one of a dielectric layer and a mask layer. The dielectric layer and/or the mask layer used by the first protecting layer 16 are significantly different from the first doping layer 11 in the physical property or the chemical property, so that when the first doping layer 11 located on the second doping region 102 and the third region 103 is removed by using an etching process or a corroding process, the first protecting layer 16 can be effectively retained.

In practical applications, the material of the first protecting layer 16 can be one or more of oxides, nitrides, carbides, and hydrogenated amorphous silicon. The oxides include one or more of silicon oxide, silicon oxynitride, alumina, titanium oxide, hafnium dioxide (HfO₂), gallium oxide (Ga₂O₃), tantalum pentoxide (Ta₂O₅), niobium pentoxide (Nb₂O₅), and other substances. The nitrides include one or more of silicon nitride, silicon carbonitride, aluminum nitride, titanium nitride (TiN), titanium carbonitride (TiCN) and other substances. The carbides include silicon carbide (SiC).

For example, when the alkali etching process is used to remove the first doping layer 11 located on the second doping region 102 and the third region 103, the dielectric layer that does not react with the used alkali can be selected as the first protecting layer 16. On the contrary, the first doping layer 11 may react with the selected alkali. Based on this, during the patterning treatment of the first doping layer 11, the first doping layer 11 located on the second doping region 102 and the third region 103 is removed, and the first doping layer 11 covered by the first protecting layer 16 is completely retained. For example, the dielectric material such as silicon oxide, silicon nitride or silicon carbide (SiCₓ) can be used as the dielectric layer. When the oxides are selected as the dielectric layer, the dielectric layer can be formed by using the thermal growth process, that is, under the condition of oxidizing atmosphere (such as air, oxygen, etc.), the oxide dielectric layer is formed on the surface of the first doping layer 11 by using the heating method.

For another example, when the laser etching process is used to remove the first doping layer 11 located on the second doping region 102 and the third region 103, the mask layer with laser ablation resistance can be used as the first protecting layer 16. On the contrary, the first doping layer 11 may be ablated by laser. Based on this, in the process of patterning treatment of the first doping layer 11, the first doping layer 11 located on the second doping region 102 and the third region 103 is removed, and the first doping layer 11 covered by the first protecting layer 16 is completely retained. Exemplarily, the material of the used mask layer can be selected from the photolithography or laser patterning mask, the printable resin mask, silicon nitride (SiNₓ), silicon oxide (SiOₓ) or silicon carbide (SiC) and other materials.

In addition, when the first protecting layer 16 is a laminated structure of the dielectric layer and the mask layer, optionally, the dielectric layer should be close to the first doping layer 11 to ensure the passivation effect of the first doping layer 11. Because the mask layer has more impurities, it should be far away from the first doping layer 11 to avoid the first doping layer 11 being contaminated.

In some embodiments, the first protecting layer 16 includes one of the boron-silicon glass (BSG) layer and the phosphorus silicon (PSG) layer. At this moment, the first protecting layer 16 can be formed by being doped together with the first doping layer 11, the process of forming the first protecting layer16 alone is saved. When the second doping layer 121 located on the first protecting layer 16 also needs to be doped, the BSG or PSG located between the first doping layer 11 and the second doping layer 121 can block the diffusion of phosphorus or boron, play a role in isolation, and better protect the first doping layer 11.

In practical applications, the material of the first protecting layer 16 can be silicon oxide. Due to the characteristics that silicon oxide does not react with alkali, when alkali is used for etching in subsequent processes, silicon oxide can better protect the integrity of the first doping layer 11. In addition, silicon oxide has a good interface passivation effect, which can passivate the dangling bond of the surface of the first doping layer 11 and inhibit the recombination of the carriers on the surface of the first doping layer 11, thus the photoelectric conversion efficiency of the cell is improved. When the material of the first protecting layer 16 is silicon oxide, the thickness of the first protecting layer 16 ranges from 20 nm to 100 nm. In order to better protect the first doping layer 11 during etching or cleaning, the first protecting layer 16 can be thicker.

As some possible embodiments, as shown in FIG. 2 and FIG. 3, a surface of the third region 103 has a textured structure. There is not an electrode disposed on the third region 103, and the third region 103 can be textured, so that there is a textured structure on the third region 103. Because the textured structure has a good light trapping effect and an anti-reflection effect, the light incident on the first surface can also be utilized, the light absorption effect of the back-contact cell on the first surface is increased, so that the back-contact cell can absorb light energy at both sides, the further utilization of light energy is realized and the power generation efficiency of the back-contact cell is improved.

As some possible embodiments, as shown in FIG. 1 to FIG. 3, a surface of the first doping region 101 and/or a surface of the second doping region 102 and/or a surface of the overlapping region 104 are polishing surfaces. At this moment, all of the surface of the first doping region 101, the surface of the second doping region 102 and the surface of the overlapping region 104 can be the polishing surfaces, so that the light incident from the second surface and passing through the back-contact cell can be re-reflected, so that there is an opportunity that the light can be reused by the back-contact cell. Thus, the photoelectric conversion efficiency of the back-contact cell is improved. In addition, the polished surface has better flatness, and the effect of subsequently forming other layers on the polishing surface may be better, the generation of interface defects is conducive to be reduced, therefore the recombination of carriers caused by defects is reduced, the passivation performance of the back-contact cell is conducive to be improved, therefore the photoelectric conversion efficiency of the back-contact cell is improved.

As some possible embodiments, as shown in FIG. 3, the back-contact cell further includes a first interface passivation layer 14, a second interface passivation layer 151 and a third interface passivation layer 152, wherein the first interface passivation layer 14 is located between the substrate 10 and the first doping layer 11, the second interface passivation layer 151 is located between the second doping layer 121 and the first protecting layer 16, and the third interface passivation layer 152 is located between the substrate 10 and the third doping layer 122. The substrate 10, the first protecting layer 16 and the first doping layer 11 are performed interface passivation by the first interface passivation layer 14, the second interface passivation layer 151 and the third interface passivation layer 152, respectively, the recombination of carriers at the interface is reduced and the transmission efficiency of the carriers is ensured.

In some embodiments, the materials of the first interface passivation layer 14, the second interface passivation layer 151 and the third interface passivation layer 152 can be one or more of oxides, nitrides, carbides and hydrogenated amorphous silicon. The oxides include one or more of silicon oxide, silicon oxynitride, alumina, titanium oxide, hafnium dioxide (HfO₂), gallium oxide (Ga₂O₃), tantalum pentoxide (Ta₂O₅), niobium pentoxide (Nb₂O₅), and other substances. The nitrides include one or more of silicon nitride, silicon carbonitride, aluminum nitride, titanium nitride (TiN), titanium carbonitride (TiCN) and other substances. The carbides include silicon carbide (SiC).

In some embodiments, when the first doping layer 11, the second doping layer 121 and the third doping layer 122 are semiconductor doping layers. The first interface passivation layer 14, the second interface passivation layer 151 and the third interface passivation layer 152 can be a tunneling oxide layer. The tunneling oxide layer allows majority carriers to tunnel into the semiconductor doping layer while blocking the passage of minority carriers, and then the majority carriers are transported laterally in the semiconductor doping layer and be collected by the electrode, the recombination of the carriers is reduced and the open-circuit voltage and short-circuit current of the back-contact cell are improved. At this moment, the tunneling oxide layer and the semiconductor doping layer form a tunneling oxide layer passivation contact structure, the excellent interface passivation and the selective collection of the carriers can be achieved, and the photoelectric conversion efficiency of the back-contact cell is improved. All of the first interface passivation layer 14, the second interface passivation layer 151 and the third interface passivation layer 152 can be the passivation layer of the silicon oxide interface. Compared with the amorphous silicon interface passivation layer which may be crystallized into polysilicon at a high temperature, the interface passivation layer of silicon oxide is more resistant to the high temperature.

As some possible embodiments, as shown in FIG. 1 to FIG. 3, the back-contact cell further includes a first surface passivation layer 13, the first surface passivation layer 13 is covered on the first doping layer 11, the second doping layer 12, the third doping layer 122 and the third region 103; and a contacting surface of the first surface passivation layer 13 and the first doping layer 11 has a first opening 130, the first electrode 20 is electrically contacted with the first doping layer 11 through the first opening 130; and a contacting surface of the first surface passivation layer 13 and the third doping layer 122 has a second opening 131, the second electrode 21 is electrically contacted with the third doping layer 122 through the second opening 131.

Based on this, a layer of a first surface passivation layer 13 is formed at the outside of the first doping layer 11, the second doping layer 121, the third doping layer 122 and the third region 103. The back-contact cell may be performed surface passivation by the first surface passivation layer 13, the dangling bonds at the first doping layer 11, the second doping layer 121, the third doping layer 122 and the third region 103 are passivated, the recombination speed of the carriers of the first surface is reduced, and the photoelectric conversion efficiency is improved. The first electrode 20 and the second electrode 21 are electrically contacted with the first doping layer 11 and the third doping layer 122 through the first opening 130 and the second opening 131, respectively. Local ohmic contact between the metal and the semiconductor is formed, the contact area of the metal electrode with the first doping layer 11 and the third doping layer 122 is reduced, the contact resistance is reduced, the recombination rate of the carriers at the electrode surface is further reduced, and the open circuit voltage is increased. At the same time, the first surface passivation layer 13 located on the third region 103 also plays a role in separating the second doping layer 121 from the third doping layer 122.

In some embodiments, the material of the first surface passivation layer 13 may be one or more of silicon nitride, silicon oxide, silicon oxynitride, alumina, silicon carbide, and amorphous silicon.

As some possible embodiments, as shown in FIG. 1 to FIG. 3, the second surface has a textured structure. There is a second surface passivation layer 18 on the second surface. The textured structure of the second surface has a good light trapping effect, the reflection of the light incident on the second surface can be reduced, and the utilization of the light is improved. The second surface passivation layer 18 plays a role in passivating the interface of the substrate 10 for the second surface, the recombination of the carriers at the interface is reduced, the transmission efficiency of the carriers is improved, thus the photoelectric conversion efficiency of the back-contact cell is improved.

In some embodiments, the material of the second surface passivation layer 18 may be one or more of silicon nitride, silicon oxide, silicon oxynitride, alumina, silicon carbide, and amorphous silicon.

As some possible embodiments, the second surface of the back-contact cell further includes an antireflection layer. The antireflection layer can be formed on the second surface passivation layer 18. The reflection of the light incident on the second surface can be reduced by the antireflection layer, the refraction of the light is improved, and the utilization of the light incident on the second surface is increased, therefore the photoelectric conversion efficiency of the back-contact cell is improved.

In some embodiments, the first surface passivation layer 13 and the second surface passivation layer 18 also play a role in antireflection. The passivation layer can also be laminated with the antireflection layer, and the whole plays a role in antireflection.

In some examples, the antireflection layer may be one or more of magnesium fluoride (MgF₂), silicon dioxide (SiO₂), alumina (Al₂O₃), zinc sulfide (ZnS), silicon nitride (SiN), titanium dioxide (TiO₂), etc.

Exemplarily, the antireflection layer may be alumina antireflection layer, and may also be antireflection layer composed of laminating silicon nitride and silicon oxide.

As some possible embodiments, as shown in FIG. 1 to FIG. 3, an area of the overlapping region 104 accounts for 5% - 95 % of an area of the first doping layer 11. Optionally, the area of the overlapping region 104 accounts for 20% - 95 % of the area of the first doping layer 11. The larger the area of the overlapping region 104, the larger the area of the first doping layer 11 covered by the second doping layer 121, that is, the larger the area of the protected first doping layer 11, the first doping layer 11 can better be protected from corrosion or damage in the subsequent process treatment. More preferably, the area of the overlapping region 104 accounts for 40% - 75% of the area of the first doping layer 11. The first protecting layer 16 and the second doping layer 121 located at the upper portion of the overlapping region should be avoided contacting with the first electrode 20. In addition, if the area of the overlapping region 104 is too large, there is a risk of electric leakage. Exemplarily, the width of the first doping region 101 may range from 80µm to 300µm, and the width of the overlapping region 104 can range from 60µm to 860µm.

Exemplarily, as shown in FIG. 1 to FIG. 3, the area of the overlapping region 104 can account for 40%, 60% or 75% of the area of the first doping layer 11.

In practical applications, the parts arranged according to the overlapping region 104, the first doping region 101, the overlapping region 104, the third region 103, the second doping region 102 and the third region 103 are called a period, and the width of a period ranges from 400µm to 2400µm.

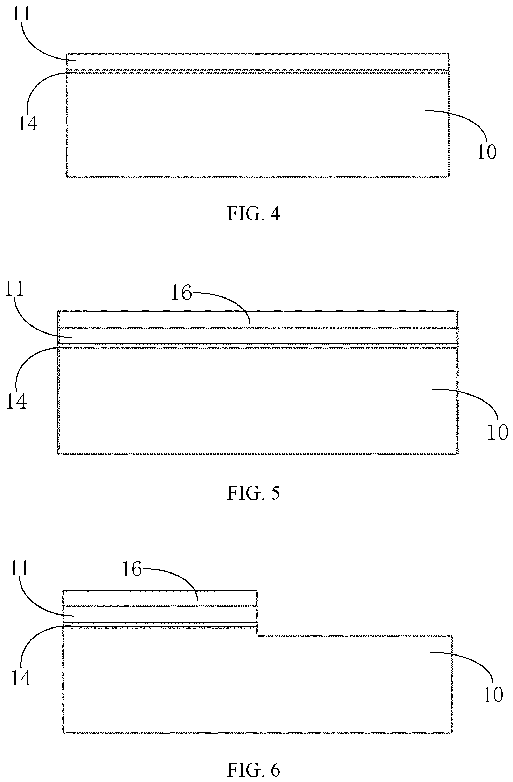

As shown in FIG. 4 to FIG. 13, based on the back-contact cell described above in any embodiment, a method for manufacturing the back-contact cell is further provided by the embodiments of the present application, which includes the steps as follows:
Step S100, providing a substrate 10, wherein the substrate 10 has the first surface and the second surface facing to each other, on the first surface, there are the first doping region 101 and the second doping region 102 arranged in the staggered way, the overlapping region 104 and the third region 103 that are located between the first doping region 101 and the second doping region 102, the overlapping region 104 is close to the first doping region 101;
Step S200, forming the first doping layer 11 on the first surface of the substrate 10;
Step S300, removing the first doping layer 11 located on the second doping region 102 and the third region 103;
Step S400, forming a doping film layer 12 on the first doping layer 11 and the first surface;
Step S500, removing the doping film layer 12 located on the third region 103 and the first doping region 101, so that the doping film layer 12 located on the overlapping region 104 is the second doping layer 121, and the doping film layer 12 located on the first surface is the third doping layer 122; and
Step S600, forming the first electrode 20 on the first doping layer 11, and forming the second electrode 21 on the third doping layer 122.

Compared with the prior art, the beneficial effects of the method for manufacturing the back-contact cell provided by the embodiments of the present application are the same as the beneficial effects of the back-contact cell stated above, which is not described here.

In practical applications, the substrate 10 needs to be performed removing damage treatment such as polishing and cleaning and so on. The thickness of the first doping layer 11, the second doping layer 121 and the third doping layer 122 ranges from 50nm to 500nm. The process of forming the first doping layer 11 on the substrate 10 and the process of forming the doping film layer 12 on the first doping layer 11 and the first surface can be a plasma chemical vapor deposition (PECVD) process, a hot filament chemical vapor deposition process, a physical vapor deposition (PVD) process, a low pressure chemical vapor deposition (LPCVD) process or a catalytic chemical vapor deposition process and so on. The process of removing the first doping layer 11 located on the second doping region 102 and the third region 103 and the process of removing the doping film layer 12 located on the third region 103 and the first doping region 101 may be laser etching process, ion milling etching process, plasma etching process, reactive ion etching process, alkali etching process, acid etching process and so on.

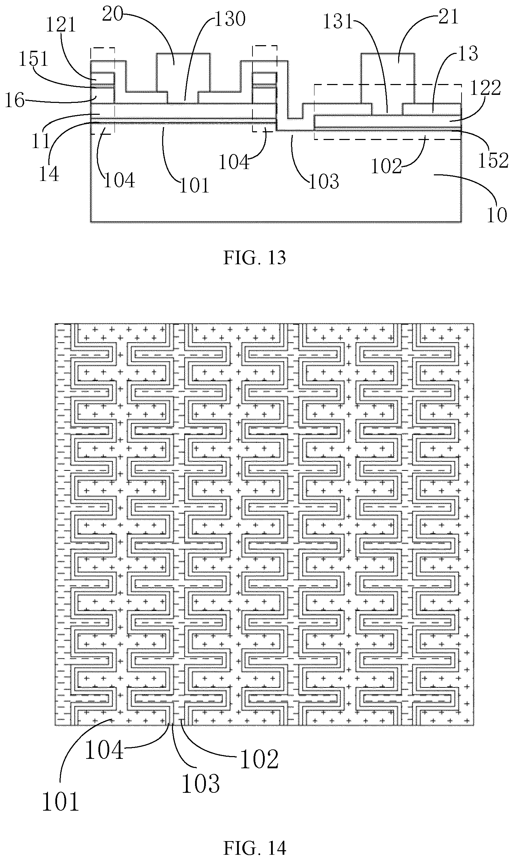

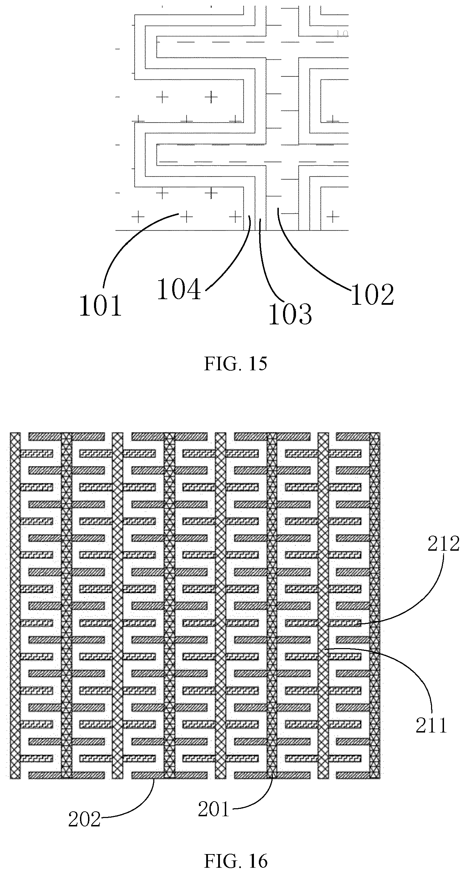

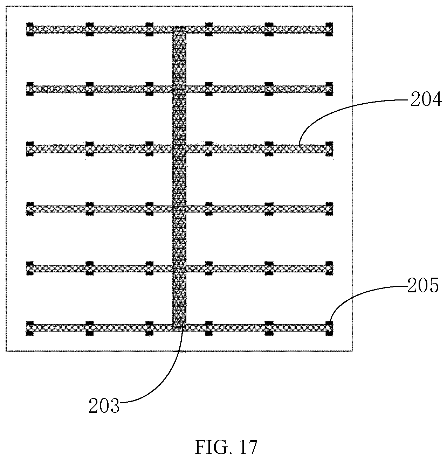

In practical applications, as shown in FIG. 13, the width of the first electrode 20 and the width of the second electrode 21 range from 5µm to 100µm. The first electrode 20 and the second electrode 21 that are formed are continuous contact electrodes. At this moment, as shown in FIG. 16, the first electrode 20 includes a first electrode main electrode 201 and a first electrode sub-gate line 202, and the second electrode 21 includes a second electrode main electrode 211 and a second electrode sub-gate line 212. The first electrode 20 and the second electrode 21 that are formed can also be local contact electrodes. As shown in FIG. 17, taking the first electrode 20 as an example, at this moment, the first electrode 20 can include a connecting electrode 203 and a fine gate line 204. The fine gate line 204 is connected to the connecting electrode 203 and current is exported through the connecting electrode 203. The continuous electrode is not in contact with the first doping layer 121, the fine gate line 204 is in contact with the first doping layer 121, or some areas on the fine gate line 204 are in contact with the first doping layer 121, and the rest areas are not in contact with the first doping layer 121. Exemplarily, as shown in FIG. 17, the connecting electrode 203 plays a role in confluence, the fine gate line 204 plays a role in transmission, and does not contact with the first doping layer 121. On the fine gate line 204, there are only local contacting points 205 in contact with the first doping layer 121. A bonding pad or an electrode output contacting point can also be disposed on the main electrode to enable the electrical energy of the cell to be output. The fine gate line 204 can also be prepared by using different electrode slurries. For example, the fine gate line 204 is composed of a conductive slurry 1 and a conductive slurry 2 after metallization heat treatment. Wherein the conductive slurry 1 has the characteristics of penetrating the dielectric film, the conductive slurry 2 does not have the characteristics of penetrating the dielectric film, the conductive slurry 1 is discontinuously distributed, the conductive slurry 2 is partially or completely covered on the conductive slurry 1, and connects the area of the conductive slurry 1.

In practical applications, the process of forming the first electrode 20 and the second electrode 21 can be electroplating process, transfer printing process (such as laser transfer printing process, thermal transfer printing process, etc.), screen printing, physical vapor deposition of metal or metal oxide electrode process, etc. Obviously, various processes can also be used in combination. For example, the electrode is firstly printed to form a power supply point, and then the electroplating process is used to form the final first electrode 20 and the second electrode 21 by powering up at the power supply point. Or, the vapor deposition of metal oxides is used. For example, transparent conductive oxide (TCO) may be used, and then the first electrode 20 and the second electrode 21 can be formed by screen printing or transfer printing.

In some embodiments, a forming method of the first doping layer 11 and the doping film layer 12 is an in-situ doping method or an ex-situ doping method. That is, the first doping layer 11 and the doping film layer 12 can be formed directly, or the intrinsic semiconductor layer and the intrinsic semiconductor film layer can also be formed first, and then the first doping layer 11 and the doping film layer 12 can be formed by being doped, respectively.

As some possible embodiments, as shown in FIG. 4 to FIG. 6, the step of removing the first doping layer 11 located on the second doping region 102 and the third region 103 is specifically as follows: forming a first protecting layer 16 on the first doping layer 11 of the first doping region 101 and the overlapping region 104; removing the first doping layer 11 and the first protecting layer 16 on the second doping region 102 and the third region 103.

In practical applications, the plasma chemical vapor deposition (PECVD) process, the atmospheric pressure vapor deposition (APCVD) process and the thermal growth process and other processes may be used to form the first protecting layer 16. The method of removing the first protecting layer 16 can be acid washing, alkali washing and water washing and so on, and the ultraviolet laser with a smaller pulse width may also be used to remove the first protecting layer. When silicon oxide is selected as the first protecting layer 16, the first protecting layer 16 can be formed by using the thermal growth process, that is, under the condition of oxidizing atmosphere (such as air, oxygen, etc.), a layer of silicon oxide is formed on the surface of the first doping layer 11 by using a heating method.

In some embodiments, when the first protecting layer 16 is silicon oxide and the first doping layer 11 is the boron-doped p-type polycrystalline silicon layer, the first protecting layer 16 and the first doping layer 11 may also be formed in one process. For example, after the formation of a layer of the intrinsic polycrystalline silicon layer, the thermal diffusion process is used to inlet gas such as BCl₃ or BBr₃ in the heating state (oxygen must be inlet during the thermal diffusion process), and the intrinsic polycrystalline silicon layer is doped to form a p-type polycrystalline silicon layer. At the same time, a layer of silicon oxide may be formed on the surface of the p-type polycrystalline silicon layer.

When the substrate 10 is the p-type silicon substrate 10, the process can be replaced by the thermal diffusion process of doped phosphorus. At this moment, the in-situ doped p-type polycrystalline silicon layer can also be replaced by the n-type polycrystalline silicon layer. The phosphorus-doped n-type polycrystalline silicon layer and silicon oxide on the phosphorus-doped n-type polycrystalline silicon layer may also be similarly formed by using the POCl₃ during the thermal diffusion.

In addition, when the first protecting layer 16 is a laminated structure of the dielectric layer and the mask layer, and the material of the dielectric layer is silicon oxide, if the first protecting layer 16 is needed to be removed, the mask layer can be patterned first, and then the first surface of the back-contact cell can be cleaned by using a solution containing fluorine, such as hydrofluoric acid (HF) or ammonium fluoride (NH₄F) and so on, so as to remove the silicon oxide at the place where the mask material is not disposed, the passivation in the subsequent process is conducive to be better performed, then the mask layer can be removed by using alkali washing.

The first doping layer 11 and the first protecting layer 16 on the second doping region 102 and the third region 103 can also be removed by using the laser etching process in one step, but the damage to the substrate 10 is large.

As some possible embodiments, as shown in FIG. 6 to FIG. 10, the step of removing the doping film layer 12 located on the third region 103 and the first doping region 101 is specifically as follows: forming a second protecting layer 17 on the doping film layer 12 located on the overlapping region 104 and the second doping region 102; removing the doping film layer 12 located on the third region 103 and the first doping region 101; and removing the second protecting layer 17. The selected material, the process treatment method and the embodiments of the second protecting layer 17 are the same as the selected material, the process treatment method and the embodiments of the first protecting layer 16. The second protecting layer 17 is used to protect the second doping layer 121 and the third doping layer 122, so that the second doping layer 121 and the third doping layer 122 may not be corroded or damaged in the subsequent cleaning or etching process. Since the second protecting layer 17 may have metal ions or other contaminations, in order to ensure that the back-contact cell is better passivated in the subsequent process, the metal ions or other contaminations are removed after the second protecting layer 17 is not required.

In some embodiments, the second protecting layer 17 includes the mask layer. Optionally, the mask layer is a layer of silicon nitride (SiNₓ), silicon oxide (SiOₓ) or silicon carbide (SiC) mask layer deposited by using the PECVD process. The process of removing the second protecting layer 17 may be laser etching. In the process of removing the second protecting layer 17, the second protecting layer 17 located on the first doping region 101 can be removed first, and then the second protecting layer 17 located on the third region 103 can be removed, at the same time, the second protecting layer 17 located on the first doping region 101 and the third region 103 can also be removed. Optionally, the second protecting layer 17 located on the first doping region 101 and the third region 103 can be removed at the same time.

As some possible embodiments, as shown in FIG. 4 to FIG. 6, before the step of forming the first doping layer 11 on the first surface of the substrate 10, the method further includes a step of forming a first interface passivation layer 14 on the first surface of the substrate 10; in the step of removing the first doping layer 11 located on the second doping region 102 and the third region 103, the method further includes a step of removing the first interface passivation layer 14 located on the second doping region 102 and the third region 103. The process of forming the first interface passivation layer 14 can be the plasma chemical vapor deposition (PECVD) process, atmospheric pressure vapor deposition (APCVD) process and thermal growth process and other processes. The process of removing the first interface passivation layer 14 can be laser etching process, ion milling etching process, plasma etching process, reactive ion etching process, alkali etching process, acid etching process and so on.

In some embodiments, the first interface passivation layer 14 can be a tunneling oxide layer, and the thickness of the tunneling oxide layer ranges from 0.5nm to 5nm.

In addition, when the first interface passivation layer 14 is a tunneling oxide layer and the first doping layer 11 is the boron-doped p-type polycrystalline silicon layer, the first interface passivation layer 14 and the first doping layer 11 can be formed in one process. That is, the tunneling oxide layer and the boron-doped p-type polycrystalline silicon layer directly grow.

As some possible embodiments, as shown in FIG. 6 to FIG. 10, after the step of removing the first doping layer 11 located on the second doping region 102 and the third region 103, and before the step of forming the doping film layer 12 on the first doping layer 11 and the first surface, the method further includes a step of forming an interface passivation film layer 15 on the first protecting layer 16 and the first surface; and in the step of removing the doping film layer 12 located on the third region 103 and the first doping region 101, the method further includes a step of removing the interface passivation film layer 15 located on the third region 103 and the first doping region 101, so that the interface passivation film layer 15 located on the first protecting layer 16 of the overlapping region 104 is a second interface passivation layer 151, and the interface passivation film layer 15 located on the first surface is a third interface passivation layer 152. The process of forming the interface passivation film layer 15 can be the plasma chemical vapor deposition (PECVD) process, the atmospheric pressure vapor deposition (APCVD) process and the thermal growth process and other processes. The process of removing the interface passivation film layer 15 can be the laser etching process, the ion milling etching process, the plasma etching process, the reactive ion etching process, the alkali etching process, the acid etching process and so on.

In some embodiments, the interface passivation film layer 15 can be a tunneling oxide layer, and the thickness of the tunneling oxide layer ranges from 1nm to 2nm.

In addition, when the interface passivation film layer 15 is a tunneling oxide layer and the doping film layer 12 is the phosphorus-doped n-type polycrystalline silicon layer, the interface passivation film layer 15 and the doping film layer 12 can be formed in one process. That is, the tunneling oxide layer and the phosphorus-doped n-type polycrystalline silicon layer directly grow.

As some possible embodiments, a way of removing the first doping layer 11 located on the second doping region 102 and the third doping region 103 and/or removing the doping film layer 12 located on the third region 103 and the first doping region 101 is alkali etching. In the process of alkali etching, because the first interface passivation layer 14 and the interface passivation film layer 15 have a thinner thickness, they can be cleaned by alkali together.

As some possible embodiments, after the step of removing the doping film layer 12 located on the third region 103, the method further includes a step of texturing the third region 103.

Optionally, texturing the third region 103 and removing the doping film layer 12 located on the third region 103 can be completed in a same process. For example, when the doping film layer 12 located on the third region 103 is removed by using the alkali etching, the textured structure can be formed on the third region 103 at the same time.

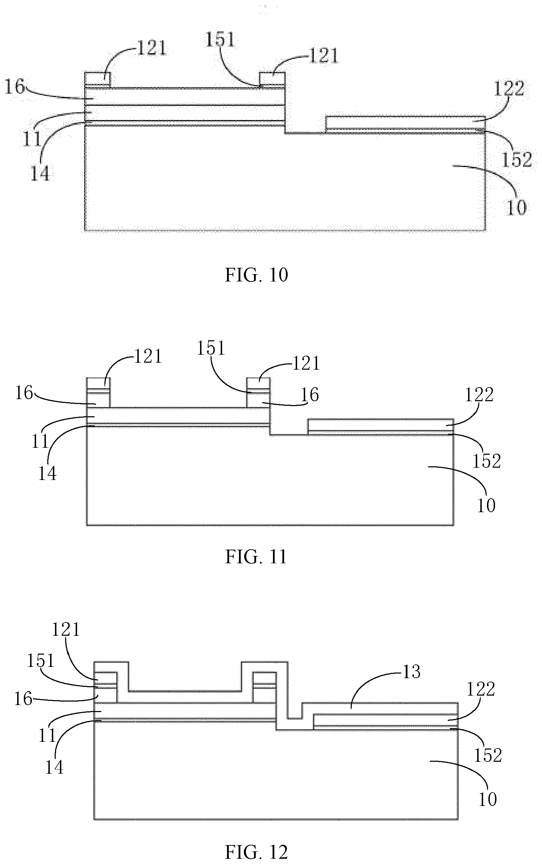

As some possible embodiments, as shown in FIG. 11 to FIG. 13, the step of forming the first electrode 20 on the first doping layer 11, and forming the second electrode 21 on the third doping layer 122 is specifically as follows: forming a first surface passivation layer 13 on the first doping layer 11, the second doping layer 121, the third doping layer 122 and the third region 103; and forming the first electrode 20 on the first surface passivation layer 13 located on the first doping layer 11, and forming the second electrode 21 on the first surface passivation layer 13 located on the third doping layer 122, the first electrode 20 is electrically contacted with the first doping layer 11 and the second electrode 21 is electrically contacted with the third doping layer 122.

In practical applications, the process of forming the first surface passivation layer 13 can be the plasma chemical vapor deposition (PECVD) process, the hot filament chemical vapor deposition process, the physical vapor deposition (PVD) process, the low pressure chemical vapor deposition (LPCVD) process or the catalytic chemical vapor deposition process and so on. When the back-contact cell has the first surface passivation layer 13, the first electrode 20 and the second electrode 21 are the continuous contact electrodes. The method of forming the first electrode 20 and the second electrode 21 can also be that the electrode slurry is coated on the first surface passivation layer 13, and then sintered to make the electrode slurry pass through the first surface passivation layer 13, and electrical contact with the first doping layer11 and the third doping layer 122 is formed, respectively. When the back-contact cell has the first surface passivation layer 13, the first electrode 20 and the second electrode 21 are local contact electrodes. The method of forming the first electrode 20 and the second electrode 21 can also be that the first opening 130 and the second opening 131 are firstly opened on the first surface passivation layer 13, and then the first electrode 20 and the second electrode 21 with local contact are formed by using the methods such as printing slurry, laser transfer printing, electroplating, chemical plating, light-induced electroplating, or physical vapor deposition method, such as vacuum evaporation, magnetron sputtering, etc. Opening methods can include laser film opening, or an etching slurry that can react with the first surface passivation layer 13 is used to open the film. By the method that electrical contact is performed through the openings, the back-contact cell can be enabled to obtain lower metal zone recombination, the high conversion efficiency of the back-contact cell is ensured. Obviously, one or the combination of more of the methods stated above may be used to form the first electrode 20 and the second electrode 21. For example, the method of a seed layer of physical vapor deposition (PVD) coordinating with printing an electrode, or the method of a screen-printed electrode slurry coordinating with the electroplating, or a combination of a laser transfer printing process method and a screen-printed sintering method is used.

When the substrate 10 is the n-type silicon substrate 10 and the first doping layer 11 is the p-type polycrystalline silicon layer, the p-type contact region is formed on the first doping region 101 and the overlapping region 104 by the method of opening film to form the electrode stated above, through the tunneling effect of the carriers, the first polar carriers of the first doping region 101 are collected by the first electrode 20 through the first doping layer 11. The n-type contact region is formed on the second doping region 102, and the second polar carriers of the second doping region 102 are collected by the second electrode 21 through the third doping layer 122. Then, the conductive slurry can be printed on the first surface passivation layer 13 and sintered to form metallized contact, a p-type metal region is formed on the p-type contact region and an n-type metal region is formed on the n-type contact region. Or the burn-through type slurry can be directly printed on the first surface passivation layer 13 to form the corresponding P-type metal region and N-type metal region. Finally, the first electrode 20 and the second electrode 21 are formed.

Exemplarily, after the first electrode 20 and the second electrode 21 are formed, there are other steps, for example, light injecting carriers or electrical injecting carriers or other heat treatment processes, as well as efficiency grading or slicing and other steps.

In some embodiments, the step of forming the third region 103 can be set before the formation of the first surface passivation film. The step of forming the third region 103 can also be set after manufacturing the back-contact cell is completed, but in this way, the partial passivation of the third region 103 may be sacrificed.

As some possible embodiments, before the step of forming the first surface passivation layer 13 on the first doping layer 11, the second doping layer 121, the third doping layer 122 and the third region 103, the method further includes a step of preforming a heat treatment process, wherein at least a part of the first doping layer 11 and/or the second doping layer 121 and/or the third doping layer 122 are crystallized during the heat treatment process. The p-type or n-type semiconductor layer can be heat-treated, so that the dopant is further distributed or the structure of the semiconductor layer is caused to be changed, which is more conducive to the improvement of battery performance. For example, when the first doping layer 11, the second doping layer 121 and the third doping layer 122 are amorphous semiconductors or microcrystalline semiconductors, at least a part of the first doping layer 11 and/or the second doping layer 121 and/or the third doping layer 122 can be enabled to be crystallized by heating annealing. The conductivity of the first doping layer 11, the second doping layer 121 and the third doping layer 122 are improved. In addition, the selective transporting of the carriers in the tunneling oxide layer can be enabled to be conducive to be performed by heating annealing. By heating, the doped elements can also be enabled to enter the tunneling oxide layer and the substrate 10, therefore the transmission resistance is reduced.

As some possible embodiments, the method also includes a step of texturing the second surface and forming the second surface passivation layer 18 on the second surface. The process of forming the second surface passivation layer 18 can be the plasma chemical vapor deposition (PECVD) process, the hot filament chemical vapor deposition process, the physical vapor deposition (PVD) process, the low pressure chemical vapor deposition (LPCVD) process or the catalytic chemical vapor deposition process and so on. Optionally, the patterning treatment of the third region 103 and the texturing of the second surface can be completed in the same process, one or more production processes is reduced. The commercial production capacity is greatly improved.

In some embodiments, the step of texturing the second surface can be after the step of forming the second doping layer 121 and the third doping layer 122. In the prior art, the step of texturing the second surface is usually carried out before the step of forming the first doping layer 11 on the first surface, so that the textured surface of the second surface is easy to be damaged during the removing process or the cleaning process of the first doping layer 11, the second doping layer 121 or the third doping layer 122. However, in the embodiments of the present application, the processing of texturing the second surface is set after forming the second doping layer 121 and the third doping layer 122, the integrity of the textured structure and the good light trapping performance of the textured structure are ensured. Especially when the textured structure of the second surface is a nano-textured structure, various cleaning processes and patterning processes such as etching and so on may almost certainly destroy the textured structure of the nano-textured surface. In recent years, the nano-microstructure is more and more widely used for the textured structure of the light receiving surface, so the advantages of textured postposition are more and more prominent. The textured structure of the nano-textured surface has a better light trapping effect, and because the light receiving surface of the back-contact cell does not have an electrode, the color of the second surface can be more beautiful after applying the textured structure of the nano-textured surface on the back-contact cell. Therefore, the textured structure of the nano-textured surface is more suitable for the back-contact cell.

Optionally, texturing the second surface, texturing the third region 103 and removing the doping film layer 12 located on the first doping region 101 can be completed in the same process. For example, when the doping film layer 12 located on the first doping region 101 is removed by using the alkali etching process using solutions such as potassium hydroxide (KOH), sodium hydroxide (NaOH) or tetramethylammonium hydroxide (TMAH), the textured structure can be formed on the third region 103 and the second surface at the same time.

In some embodiments, the step of forming the second surface passivation layer 18 can be performed simultaneously with the step of forming the first surface passivation layer 13.

In some embodiments, after forming the second surface passivation layer 18, a layer of the antireflection layer can also be formed on the second surface passivation layer 18.

The present application is described in combination with specific embodiments below, the listed embodiments are only used to explain the present application, and are not used to limit the scope of the present application.

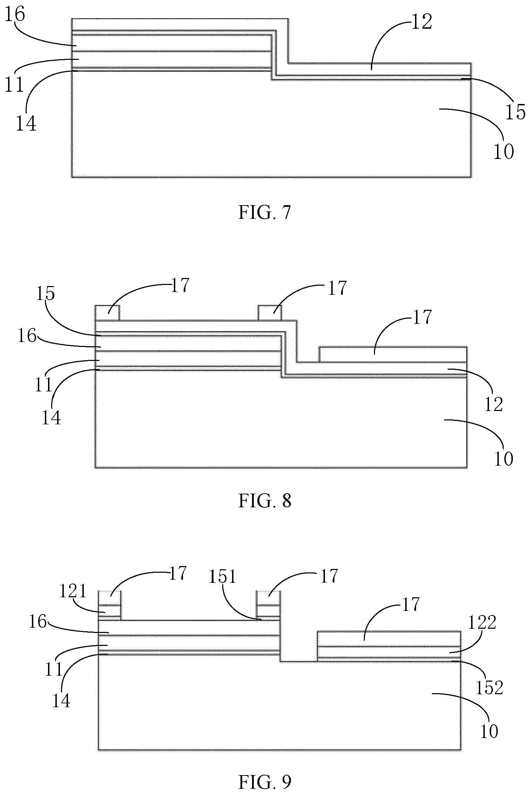

Manufacturing the n-type back-contact cell shown in FIG. 1 is taken as an example, the manufacturing method is specifically as follows:
Step 1, an n-type silicon substrate 10 is provided, and then the n-type silicon substrate 10 is performed the treatment of removing the damage such as polishing and cleaning and so on in turn;
Step 2, a layer of silicon oxide tunneling oxide layer is deposited on the first surface of the n-type silicon substrate 10 by using the PECVD devices and regarded as the first interface passivation layer 14;
Step 3, as shown in FIG. 4 and FIG. 5, a layer of the intrinsic polycrystalline silicon layer is deposited on the first interface passivation layer 14 by using the PECVD devices, and then by using thermal diffusion process, the intrinsic polycrystalline silicon layer is doped with BCl₃ gas being inlet in the heating state. At the same time, a boron-doped p-type polycrystalline silicon layer and a silicon oxide layer located on the surface of the p-type polycrystalline silicon layer and regarded as the first protecting layer 16 are formed.
Step 4, as shown in FIG. 6, ultraviolet laser is used to remove the silicon oxide layer on the third region 103 and the second doping region 102, and then the first interface passivation layer 14, the p-type polycrystalline silicon layer and the first protecting layer 16 on the third region 103 and the second doping region 102 are removed by using the alkali etching process.
Step 5, a layer of a silicon oxide layer is deposited on the first protecting layer 16, the third region 103 and the second doping region 102 and regarded as an interface passivation film layer 15 by using the PECVD devices.
Step 6, a layer of the phosphorus-doped n-type polycrystalline silicon layer is deposited on the interface passivation film layer 15 to form the structure shown in FIG. 7 by using the PECVD devices.
Step 7, as shown in FIG. 8, a layer of the silicon nitride mask layer is deposited on the n-type polycrystalline silicon layer and regarded as the second protecting layer 17 by using the PECVD devices, and then the second protecting layer 17 of the first region and the third region 103 is removed by using the laser.
Step 8, as shown in FIG. 9, the n-type polycrystalline silicon layer and the interface passivation film layer 15 on the first doping region 101 and the third region 103 are removed by using the alkali treatment process, so that the interface passivation layer 15 located on the first protecting layer 16 of the overlapping region 104 is the second interface passivation layer 151, the interface passivation film layer 15 located on the first surface is the third interface passivation layer 152, and the third region 103 and the second surface are textured at the same time.
Step 9, as shown in FIG. 10, the second protecting layer 17 is removed by using the laser.
Step 10, as shown in FIG. 11, the first protecting layer 16 on the first doping region 101 is removed by using the alkali etching process.
Step 11, as shown in FIG. 12, a layer of the silicon nitride is deposited on the first doping region 101, the overlapping region 104, the third region 103 and the second doping region 102 and regarded as the first surface passivation layer 13 by using the PECVD devices. At the same time, a layer of the silicon nitride is deposited on the textured structure of the second surface and regarded as the second surface passivation layer 18.
Step 12, as shown in FIG. 13, the first opening 130 is opened by using the laser on the first surface passivation layer 13 at the first doping region 101, and then the method of printing the conductive slurry is used to form the first electrode 20, the first electrode 20 is electrically contacted with the first doping layer 11 through the first opening 130. The second opening 131 is opened by using the laser on the first surface passivation layer 13 at the second doping region 102, and then the method of printing the conductive slurry is used to form the second electrode 21, the second electrode 21 is electrically contacted with the third doping layer 122 through the second opening 131. A back-contact cell is formed.

In the description of the above exemplary embodiments, the specific features, structures, materials or characteristics may be combined in any one or more embodiments or examples in a suitable manner.

The foregoing descriptions are merely detailed embodiments of the present disclosure, but the protection scope of the present disclosure is not limited thereto. Any changes or substitutions that can be easily thought of by those familiar with the technical field within the technical scope disclosed in the present disclosure should be covered by the protection scope of the present disclosure. Therefore, the protection scope of the present disclosure should be subjected to the protection scope of the claims.

## Claims

1. A back-contact cell, comprising:
a substrate, wherein the substrate has a first surface and a second surface facing to each other, on the first surface, there are a first doping region and a second doping region arranged in a staggered way, an overlapping region and a third region that are located between the first doping region and the second doping region, the overlapping region is close to the first doping region;
a first doping layer formed on the first doping region and the overlapping region;
a second doping layer formed on the first doping layer, wherein the second doping layer is only located at an upper portion of the overlapping region, and a conductive type of the first doping layer is opposite to a conductive type of the second doping layer;
a third doping layer formed on the second doping region, wherein a conductive type of the third doping layer is opposite to the conductive type of the first doping layer; and
a first electrode and a second electrode, wherein the first electrode is electrically contacted with the first doping layer, and the second electrode is electrically contacted with the third doping layer.

2. The back-contact cell according to claim 1, wherein the back-contact cell further comprises a first protecting layer that is located at the upper portion of the overlapping region and located between the first doping layer and the second doping layer.

3. The back-contact cell according to claim 2, wherein the first protecting layer comprises at least one of a dielectric layer and a mask layer.

4. The back-contact cell according to claim 3, wherein the first protecting layer comprises one of a boron-silicon glass layer and a phosphorus silicon glass layer.

5. The back-contact cell according to claim 1, wherein a surface of the third region has a textured structure.

6. The back-contact cell according to claim 1, wherein a surface of the first doping region and/or a surface of the second doping region and/or a surface of the overlapping region are polishing surfaces.

7. The back-contact cell according to claim 2, wherein the back-contact cell further comprises a first interface passivation layer, a second interface passivation layer and a third interface passivation layer, the first interface passivation layer is located between the substrate and the first doping layer, the second interface passivation layer is located between the second doping layer and the first protecting layer, and the third interface passivation layer is located between the substrate and the third doping layer.

8. The back-contact cell according to claim 1, wherein the substrate is an n-type substrate, the first doping layer is a p-type doping layer, the second doping layer and the third doping layer are n-type doping layers; or
the substrate is p-type substrate, the first doping layer is the n-type doping layer, the second doping layer and the third doping layer are the p-type doping layers.

9. The back-contact cell according to claim 1, wherein the back-contact cell further comprises a first surface passivation layer, the first surface passivation layer is covered on the first doping layer, the second doping layer, the third doping layer and the third region; and
a contacting surface of the first surface passivation layer and the first doping layer has a first opening, the first electrode is electrically contacted with the first doping layer through the first opening; and a contacting surface of the first surface passivation layer and the third doping layer has a second opening, the second electrode is electrically contacted with the third doping layer through the second opening.

10. The back-contact cell according to claim 1, wherein an area of the overlapping region accounts for 5% - 95 % of an area of the first doping layer.

11. The back-contact cell according to claim 1, wherein an area of the overlapping region accounts for 40% - 75% of an area of the first doping layer.

12. A method for manufacturing the back-contact cell according to any one of claims 1-11, comprising:
providing a substrate, wherein the substrate has the first surface and the second surface facing to each other, on the first surface, there are the first doping region and the second doping region arranged in the staggered way, the overlapping region and the third region that are located between the first doping region and the second doping region, the overlapping region is close to the first doping region;
forming the first doping layer on the first surface of the substrate;
removing the first doping layer located on the second doping region and the third region;
forming a doping film layer on the first doping layer and the first surface;
removing the doping film layer located on the third region and the first doping region, so that the doping film layer located on the overlapping region is the second doping layer, and the doping film layer located on the first surface is the third doping layer; and
forming the first electrode on the first doping layer, and forming the second electrode on the third doping layer.

13. The method for manufacturing the back-contact cell according to claim 12, wherein the step of removing the first doping layer located on the second doping region and the third region is specifically as follows:
forming a first protecting layer on the first doping layer of the first doping region and the overlapping region;
removing the first doping layer and the first protecting layer on the second doping region and the third region; and/or
the step of removing the doping film layer located on the third region and the first doping region is specifically as follows:
forming a second protecting layer on the doping film layer located on the overlapping region and the second doping region;
removing the doping film layer located on the third region and the first doping region; and
removing the second protecting layer.

14. The method for manufacturing the back-contact cell according to claim 13, wherein before the step of forming the first doping layer on the first surface of the substrate, the method further comprises a step of forming a first interface passivation layer on the first surface of the substrate;
in the step of removing the first doping layer located on the second doping region and the third region, the method further comprises a step of removing the first interface passivation layer located on the second doping region and the third region; and/or
after the step of removing the first doping layer located on the second doping region and the third region, and before the step of forming the doping film layer on the first doping layer and the first surface, the method further comprises a step of forming an interface passivation film layer on the first protecting layer and the first surface; and
in the step of removing the doping film layer located on the third region and the first doping region, the method further comprises a step of removing the interface passivation film layer located on the third region and the first doping region, so that the interface passivation film layer located on the first protecting layer of the overlapping region is a second interface passivation layer, and the interface passivation film layer located on the first surface is a third interface passivation layer.

15. The method for manufacturing the back-contact cell according to claim 12, wherein a forming method of the first doping layer and the doping film layer is an in-situ doping method or an ex-situ doping method.

16. The method for manufacturing the back-contact cell according to claim 12, wherein after the step of removing the doping film layer located on the third region, the method further comprises a step of texturing the third region.

17. The method for manufacturing the back-contact cell according to claim 12, wherein the step of forming the first electrode on the first doping layer, and forming the second electrode on the third doping layer is specifically as follows:
forming a first surface passivation layer on the first doping layer, the second doping layer, the third doping layer and the third region; and
forming the first electrode on the first surface passivation layer located on the first doping layer, and forming the second electrode on the first surface passivation layer located on the third doping layer, the first electrode is electrically contacted with the first doping layer and the second electrode is electrically contacted with the third doping layer.

18. The method for manufacturing the back-contact cell according to claim 17, wherein before the step of forming the first surface passivation layer on the first doping layer, the second doping layer, the third doping layer and the third region, the method further comprises a step of preforming a heat treatment process, wherein at least a part of the first doping layer and/or the second doping layer and/or the third doping layer are crystallized during the heat treatment process.

19. The method for manufacturing the back-contact cell according to claim 12, wherein a way of removing the first doping layer located on the second doping region and the third doping region and/or removing the doping film layer located on the third region and the first doping region is alkali etching.
